(19) **Europäisches Patentamt / European Patent Office / Office européen des brevets**

(11) **EP 1 734 157 B1**

(12) **EUROPEAN PATENT SPECIFICATION**

(45) Date of publication and mention
of the grant of the patent:
**06.10.2010 Bulletin 2010/40**

(51) Int Cl.:
***C30B 29/06*** *(2006.01)*    ***C30B 15/00*** *(2006.01)*

(21) Application number: **06011832.0**

(22) Date of filing: **08.06.2006**

(54) **Production process of silicon single crystal**

Verfahren zur Herstellung eines Silizium Einkristalles

Procédé pour la fabrication d'un monocristal de silicium

(84) Designated Contracting States:
**DE**

(30) Priority: **15.06.2005 JP 2005175593**

(43) Date of publication of application:
**20.12.2006 Bulletin 2006/51**

(73) Proprietor: **Siltronic AG**
**81737 München (DE)**

(72) Inventors:
- **Kishida, Yutaka**
 **Chiba 292-0042 (JP)**
- **Takebayashi, Seiki**
 **Chiba, 292-0042 (JP)**
- **Tamaki, Teruyuki**
 **Chiba, 299-1146 (JP)**

(74) Representative: **Staudacher, Wolfgang et al**
**Siltronic AG**
**Corporate Intellectual Property**
**Hanns-Seidel-Platz 4**
**81737 München (DE)**

(56) References cited:
**US-A1- 2003 051 658**

- **PATENT ABSTRACTS OF JAPAN vol. 018, no. 511 (C-1253), 27 September 1994 (1994-09-27) & JP 06 172081 A (KOMATSU DENSHI KINZOKU KK), 21 June 1994 (1994-06-21)**
- **MAEDA S ET AL: "Oxygen concentration in Czochralski silicon crystals depending on silicon monoxide evaporation from boron doped silicon melts" JOURNAL OF CRYSTAL GROWTH, ELSEVIER, AMSTERDAM, NL, vol. 192, no. 1-2, 15 August 1998 (1998-08-15), pages 117-124, XP004141543 ISSN: 0022-0248**
- **PATENT ABSTRACTS OF JAPAN vol. 1995, no. 02, 31 March 1995 (1995-03-31) & JP 06 316481 A (KAWASAKI STEEL CORP), 15 November 1994 (1994-11-15)**
- **PATENT ABSTRACTS OF JAPAN vol. 1997, no. 10, 31 October 1997 (1997-10-31) & JP 09 157085 A (SHIN ETSU HANDOTAI CO LTD), 17 June 1997 (1997-06-17) & EP 0 776 997 A (SHIN-ETSU HANDOTAI COMPANY LIMITED) 4 June 1997 (1997-06-04)**
- **PATENT ABSTRACTS OF JAPAN vol. 1998, no. 11, 30 September 1998 (1998-09-30) & JP 10 167881 A (KOMATSU ELECTRON METALS CO LTD), 23 June 1998 (1998-06-23)**
- **PATENT ABSTRACTS OF JAPAN vol. 018, no. 032 (C-1154), 18 January 1994 (1994-01-18) & JP 05 262593 A (KAWASAKI STEEL CORP), 12 October 1993 (1993-10-12)**
- **PATENT ABSTRACTS OF JAPAN vol. 2000, no. 10, 17 November 2000 (2000-11-17) & JP 2000 203987 A (TOSHIBA CERAMICS CO LTD), 25 July 2000 (2000-07-25)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical field

The present invention relates to production techniques for silicon single crystal by Czochralski method (hereinafter referred to as CZ method).

Background Art

Oxygen in a silicon wafer has an operation improving characteristics of device by trapping contaminant atoms brought into the wafer in production processes of device (intrinsic gettering operation). Therefore, oxygen concentration in a silicon single crystal has to be kept within a given range over the region spread throughout crystal fixed diameter part.

The oxygen brought in a silicon single crystal stems from the surface of quartz crucible dipped in molten silicon. In this occasion, oxygen is brought into crystal through molten silicon. In the conventional CZ method, there has been a problem that the oxygen concentration is not uniform in the pulling-up direction of crystal. The reasons are thought as follows: (1) a change of contact area of quartz crucible with melt due to decrease of melt in a crucible in the growth of crystal, (2) a change of the amount of oxygen eluted from crucible due to temperature changes resulting from furnace environments during pulling-up, and (3) a change of transport efficiency of oxygen into crystal due to changes of melt flowing state. However, no quantitative experimental approvals to support these three factors have been reported, so the contribution of the three factors to the concentration of crystal is still not clear. On the other hand, in actual productions of silicon single crystal, several methods are proposed with respect to the oxygen concentration in crystal, in response to a solidification rate or growing length of crystal in the growth, the methods include the adjustments of such as crucible rotation rate, pressure in furnace, flow rate of atmosphere gas, application of static magnetic fields or combination of several parameters thereof (hereinafter referred to as operational parameters) (see patent reference 1, patent reference 2, patent reference 3, and patent reference 4).

It is possible to adjust an oxygen concentration in crystal by adjusting operational parameters. To do this, a lot of crystal pulling-up are required to search a relation between the data of oxygen concentration in crystal and results of various changes of operational parameters, and there needs a work to determine an adjustment procedure for operational parameters in crystal growth. However, as shown in reference 3, several repeats of adjustment procedure of vexatious operational parameters for a component deterioration factor, a product change factor or the like are necessary in the case that a quality standard of crystal is changed, a production furnace of crystal is replaced, member constitution such as insulation and heater in a furnace is changed, molten amount of feedstock is increased; even without the foregoing case, in the case that furnace body becomes aging or temperature environment in a furnace is changed resulting from the change of heating environment due to the deterioration of furnace members etc. Additionally, a recent scale up of silicon single crystal from 8 to 12 inch size involving a scale up of furnace leads to exponentially increased costs and times of crystal pulling-up for the adjustment of oxygen concentration in silicon single crystal. Thus, the conventional try and error method yields very poor adaptability and applicability to a new quality standard and changes of operational environment.

Patent reference 1:
Japanese Unexamined Patent Publication H05-262593
Patent reference 2:
Japanese Unexamined Patent Publication H06-172081
Patent reference 3:
Unexamined Patent Publication H09-157085
Patent reference 4:
Japanese Unexamined Patent Publication H10-167881
Patent reference 5:
Japanese Unexamined Patent Publication H06-316481 teaches a method for obtaining a single crystal having a desired oxygen concentration by partly covering the free surface of the melt under specified conditions.
Non-patent reference 6:

Maeda et al., "Oxygen concentration in Czochralski silicon crystals depending on silicon monoxide evaporation from boron doped silicon melts", Journal Of Crystal Growth, Elsevier, Amsterdam, NL, vol.192, no.1-2, 15 August 1998, pages 117-124, is a report concluding that the radial oxygen distribution in a silicon crystal is much influenced by the silicon monoxide evaporation which is activated by means of boron doping into the silicon melt.

Disclosure of the Invention

Problems to be solved by the Invention

The present invention is based on focusing an attention to the foregoing conventional methods, and an object of the invention is to provide a production process for obtaining a silicon single crystal with a uniform distribution of oxygen concentration in a flexible response to an application of new quality standard, changes of operational environment, scale up of process and the like.

Means to solve the Problems

In order to achieve the above object, the invention as set forth in claim 1 is a production process for silicon single crystal by Czochralski method using quartz crucible comprising: estimating an oxygen concentration in a silicon single crystal in the growth on the basis of a relation of three parameters among a crucible rotation rate ($\Omega$), a crucible temperature (T), and a ratio ($\beta$) of a contact area of molten silicon with an inner wall of crucible and a contact area of molten silicon with an atmosphere gas; and controlling the oxygen concentration in the silicon single crystal by associating the temperature (T) with the ratio (p) by $1/\beta \times Exp$ (-E/T) as a function using a dissolution energy (E) of quartz into molten silicon to conform the oxygen concentration estimated to a target concentration.

Further, the invention of claim 2 is the production process for silicon single crystal of claim 1 wherein the rotation rate ($\Omega$) is controlled in response to changes of the ratio ($\beta$) and the temperature (T).

Further, the invention of claim 3 is the production process for silicon single crystal of claim 1 wherein power supplying to a heater heating the crucible is controlled in response to changes of the rotation rate ($\Omega$) and the ratio ($\beta$).

Further, the invention of claim 4 is the production process for silicon single crystal of claim 1 wherein a relative position between the crucible and the heater heating the crucible is controlled in response to changes of the rotation rate ($\Omega$) and the ratio ($\beta$).

Further, the invention of claim 5 is the production process for silicon single crystal of claim 1 wherein a growth rate of silicon single crystal is controlled in response to changes of the rotation rate ($\Omega$) and the ratio ($\beta$) .

In the present invention, among a lot of controllable parameters in the production of silicon single crystal by Czochralski method using quartz crucible, three parameters (T, $\beta$,$\Omega$) are the main factors to determine an oxygen concentration of crystal and the parameters are independent of component deterioration factor and product change factor.

(1) T: crucible temperature
(2) $\beta$ : ratio of contact area = contact area of molten silicon with an atmosphere gas / contact area of molten silicon with an inner wall of crucible
(3) $\Omega$ : crucible rotation rate
Crucible temperature T as a first parameter is an average temperature of a part of a quartz crucible contacting with the liquid surface of molten silicon. By the temperature T, an oxygen amount eluted from the surface of quartz crucible is determined. Although an actual crucible temperature is thought to have a distribution of high or low temperature depending on the position, an inner temperature of crucible is homogenized by a heat transfer through convection of molten silicon, therefore, it is not so influenced by positions for measuring temperature. Accordingly, the temperature can be thought to be represented by a temperature at one point measured with a temperature sensor such as thermocouple or blackbody thermometer set directly underneath quartz crucible on a crucible rotation shaft (see Japanese Unexamined Patent Publication S56-125296 and Japanese Unexamined Patent Publication H06-298593.)

Ratio of contact area $\beta$ as a second parameter is a value that contact area of molten silicon with an atmosphere gas is divided by contact area of molten silicon with an inner wall of crucible, the value is a necessary indicator to determine the transfer balance of oxygen in pulling-up of crystal. The value $\beta$ can be geometrically calculated based on the geometrical shape of inner surface of quartz crucible in use and melt volume in pulling-up of crystal. Here, the melt volume in pulling-up of crystal can be calculated by subtracting the crystal weight pulled up from the weight of silicon feedstock filled in, or
by converting the change of load on a crucible rotation shaft loaded prior to pulling-up into the volume of molten silicon. Denominator in the equation, i.e., contact area of molten silicon with an atmosphere gas is a value obtained by subtracting the cross section of crystal from the area of melt surface corresponding to melt amount in pulling-up. Additionally, the ratio of contact area $\beta$ is a parameter having a physical meaning different from a crystal solidification ratio (see patent reference 1) and a crystal pulling-up length (see patent reference 4) which are controlling parameters in the conventional adjusting method of oxygen concentration.

Crucible rotation rate $\Omega$ as a third parameter is a parameter to determine the thickness of flow boundary layer formed in the interface of melt contacting a crucible surface by rotation of quartz crucible. The change in thickness of flow boundary layer is a change of moving speed of oxygen transferring to the melt from crucible surface. Accordingly, it is thought that $\Omega$ is an essential indicator to determine the transfer balance of oxygen in pulling-up of crystal. The value of $\Omega$ can be measured with an encoder set up on crucible rotation shaft.

In the present invention, oxygen concentration brought into crystal on the growing surface of crystal is thought to be determined by the foregoing three control parameters in the growth of crystal, each of the parameters and the oxygen concentration in crystal are thought to be correlated in the following formula (1).

$$O_p \ (\Omega, \ T, \ \beta) = A \times F \ (\Omega) \times G \ (T) \times H \ (\beta) + B \ \ \ldots \ \text{Equation (1)}$$

where A is a conversion constant, B is a constant, F, G and H are functions of crucible rotation rate $\Omega$, crucible temperature T and ratio of contact area $\beta$, respectively. Characteristics of functions of F, G and H with respect to $\Omega$, T and $\beta$ are, for example, given in a power-law form with respective constants of f, g and h as follows:

$$F \ (\Omega) = \Omega^{0.5} + f$$
$$G \ (T) = T + g \ \ \ \ \ \ \ \ldots \ \text{Equation (2)}$$
$$H \ (\beta) = \beta^{-1} + h$$

Oxygen concentration in crystal $O_p$ can be estimated by giving respective operational parameters of $\Omega$, T, $\beta$ in the actual growth of crystal into Equations (1) and (2).

Additionally, in Equation (2), since the function G (T) is thought to be proportional to a dissolving speed of quartz crucible into molten silicon, expressing a dissolution energy
of quartz into silicon as E, it is reasonable to express it as the following:

$$G \ (T) = \text{Exp} \ (-E/T) \ \ \ \ \ \ldots \ \ \ \text{Equation (3)}$$

Further, by putting function H ($\beta$) with h=0, oxygen concentration becomes a simple form which is inversely proportional to the ratio of the area $\beta$.

In this case, a function I ($\beta$, T) of H ($\beta$) multiplied by G (T) is in the following form.

$$I \ (\beta, \ T) = 1/\beta \text{Exp} \ (-E/T) \ \ \ \ \ldots \ \text{Equation (4)}$$

This function I ($\beta$, T) is an equation estimating oxygen concentration in melt in a boundary layer model by Hoshikawa and Hirata (Japanese Association for Crystal Growth Corporation Vol.15.2 (1988), p.215), equation (14)) corresponding to an approximate expression in the following conditions: oxygen concentration CS of the part contacting a surface of quartz crucible is larger than the oxygen concentration Ca on a free surface of melt (Ca>Cs); ratio $\alpha$ of thickness of oxygen concentration boundary layer of melt to the surface of quartz crucible and thickness of oxygen concentration boundary layer to a free surface is sufficiently smaller than the ratio of contact area $\beta$ ($\alpha<<\beta$). Namely, using the following Equation (5) showing an approximate oxygen concentration in melt, it can be thought to estimate an oxygen concentration in crystal in a more precise way.

$$O_p \ (\Omega, \ T, \ \beta) = A \times F \ (\Omega) \times 1/\beta \times \text{Exp} \ (-E/T) + B \ \ \ldots \text{Equation (5)}$$

Then, when the crystal oxygen concentration $O_p$ estimated by Equations (1) or (5) differs from a stipulated quality value of oxygen concentration, the crucible rotation rate $\Omega$ and crucible temperature T are to be changed suitably in the growth of crystal to satisfy the following Equation (6).

$$\left| O_p \left( \Omega, \ T, \ \beta \right) \ - \ O_t \left( \beta \right) \right| \ \leq \ \Delta \qquad \dots \ \text{Equation (6)}$$

where $\Delta$ is an acceptable variation of oxygen concentration of the crystal growing part, which is determined by a quality specification.

As described above, three parameters are controlled in the growth of crystal according to Equations (1) or (5), or Equation (6), which can always place the oxygen concentration of crystal within a quality specification.

In this respect, while crucible rotation rate can be changed directly from a panel of furnace, there is a problem that crucible temperature cannot be directly set up from the panel. For the problem, the crucible temperature is indirectly controlled by adjusting heater power in order to maintain pulling-up crystal in a fixed diameter through changing each of operational parameters in the several methods below listed:

(1) power of heaters for heating a crucible is adjusted. For example, when a crucible is equipped with two kinds of heaters of which a heater heating a side wall (main heater) and heater heating the bottom of crucible (auxiliary heater), the power supplying to the main heater is decreasingly adjusted not to decrease the crystal diameter in pulling-up while raising the power supplying to the auxiliary heater to raise the temperature of crucible.

(2) relative position between a crucible and heater is adjusted. For this way, a crucible may be moved up and down, or a mechanism for directly moving a main heater may be applied (see Japanese Unexamined Patent Publication H06-219887).

(3) growing rate of crystal is adjusted. For this way, because of the changes of heat value due to solidification in response of the change of crystal growing rate, the changes of heat value from heater is required to keep the crystal diameter, so the crucible temperature can be indirectly increased or decreased by changing a necessary heating power of heater depending on the value.

(4) crucible rotation rate is changed. This way takes advantage of lowering heat transfer into melt due to the suppression of convection of melt itself through the increase of turning moment of melt by the increase of crucible rotation rate. When crucible rotation rate increases, heat transfer into crystal from melt is lowered, so it is necessary to increase heat value from heater to keep the crystal diameter, in response to this, heating power of heater is required to increase, resulting in indirectly raising the crucible temperature. However, it should be also considered that the crucible rotation rate depends not only on crucible temperature but also on the thickness of flow boundary layer described above, which affects oxygen concentration.

Effect of the Invention

According to the production process of the present invention, a silicon single crystal with a uniform distribution of oxygen concentration can be produced in a high yield without being affected by changes such as crystal diameter and initial amount of melt feedstock.

Best mode for carrying out the invention

Best mode for carrying out the invention will be described in the following.

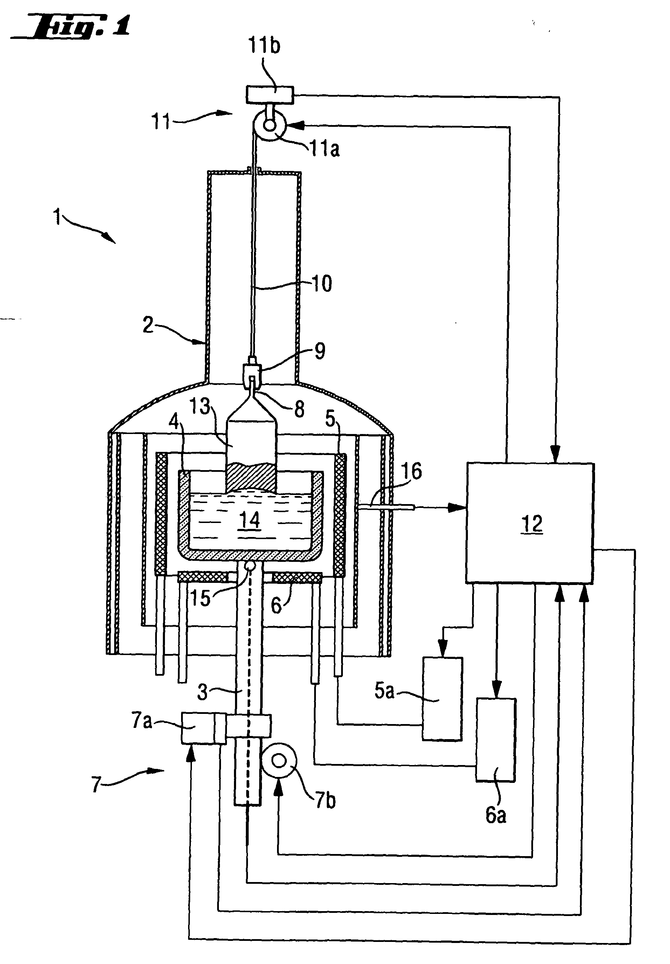

Fig. 1 is a schematic view depicting an embodiment of production apparatus used for producing a silicon single crystal according to the production process of the present invention.

The production apparatus 1 is equipped with a pulling furnace 2, a crucible shaft 3 set up passing through the bottom center of the pulling furnace 2, a quartz crucible 4 set up on the top of the crucible shaft 3, a main heater 5 in a ring shape for heating the quartz crucible 4 and the periphery from the circumference, an auxiliary heater 6 in a ring shape surrounding the crucible shaft 3, a crucible support drive mechanism 7 hoisting and rotating the crucible shaft 3, a seed chuck 9 holding a seed crystal 8, a pulling wire 10 suspending the seed chuck 9, a wire winding mechanism 11 for winding the pulling wire 10, and a controller 12. Number 13 is a silicon single crystal in the growth and 14 is molten silicon inside the quartz crucible 4. The silicon single crystal 13 is pulled up by gradually winding the pulling wire 10 in time with crystal growing rate from molten silicon.

The crucible support drive mechanism 7 is equipped with a crucible rotating servomotor 7a and crucible hoisting servomotor 7b. The wire winding mechanism 11 is equipped with a wire winding servomotor 11a and a load cell 11b.

Additionally, inside the furnace 2, there equipped are a thermocouple (or blackbody thermometer) 15 for measuring the temperature of quartz crucible 4 and a radiation thermometer 16 for measuring the radiant heat (heater temperature) inside the furnace 2. The thermocouple 15 is set on the outer surface of the quartz crucible 4. The radiation thermometers 16 are set in the peripheries of the main heater 5 and auxiliary heater 6.

To the main heater 5 and auxiliary heater 6, power is supplied from respective sources 5a and 6a.

In the controller 12, measurements of temperature by the thermocouple 15, measurements of weight by the load cell 11b, rotation rate of the crucible rotating servomotor 7a are inputted. On the basis of these input data, the controller 12 drives the crucible rotating servomotor 7a, crucible hoisting servomotor 7b, source of main heater 5a, source of auxiliary heater 6a, wire winding servomotor 11a and the like.

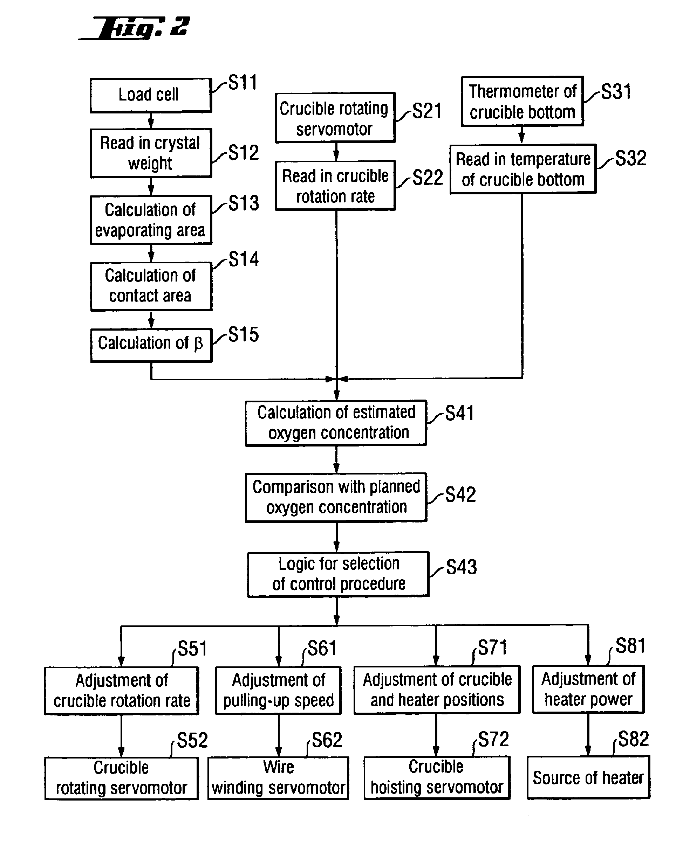

Fig.2 is a flow diagram showing a control procedure of various operational parameters in pulling-up of silicon single crystal. According to the diagram, the controller 12 controls respective operational parameters such as crucible rotation rate, pulling-up speed of crystal, heater power from the start point of growth of single crystal in a fixed diameter part to the end point.

The controller 12 particularly performs the following procedures.

First, the controller 12 reads in measurements of weight by the load cell 11b, via calculations of evaporating area and contact area, calculates a ratio $\beta$ of contact area (S11 to S15). In addition, it reads in the rotation rate $\Omega$ of crucible rotation servomotor 7a (crucible rotation rate) (S21 and S 22). In addition, it reads in measurements of temperature (crucible temperature) T by the thermocouple 15 (thermometer of crucible bottom) (S31 and S32).

Next, the controller 12 calculates an estimated oxygen concentration $O_p$ (Q, T, $\beta$) (S41) by using the ratio $\beta$ of contact area, crucible rotation rate Q and crucible temperature T obtained from the respective steps of S15, S22 and S32. The Equations (1) and (5) are used for this calculation.

It compares the estimated oxygen concentration $O_p$ ($\Omega$, T, $\beta$) calculated in S41 step with a stipulated quality value $O_t$ (S42).

Next, based on the comparison results in the step of S42, it selects a control means (S43).

Then, based on the control means selected in the step of S43, it controls the crucible rotating servomotor 7a (S51 and S52), wire winding servomotor 11a (S61 and S62), crucible hoisting servomotor 7b (S71 and S72), heater source 5a, 18S (S81 and S82) and the like.

Below, Comparative examples and Examples of the present invention will be described.

Comparative example 1

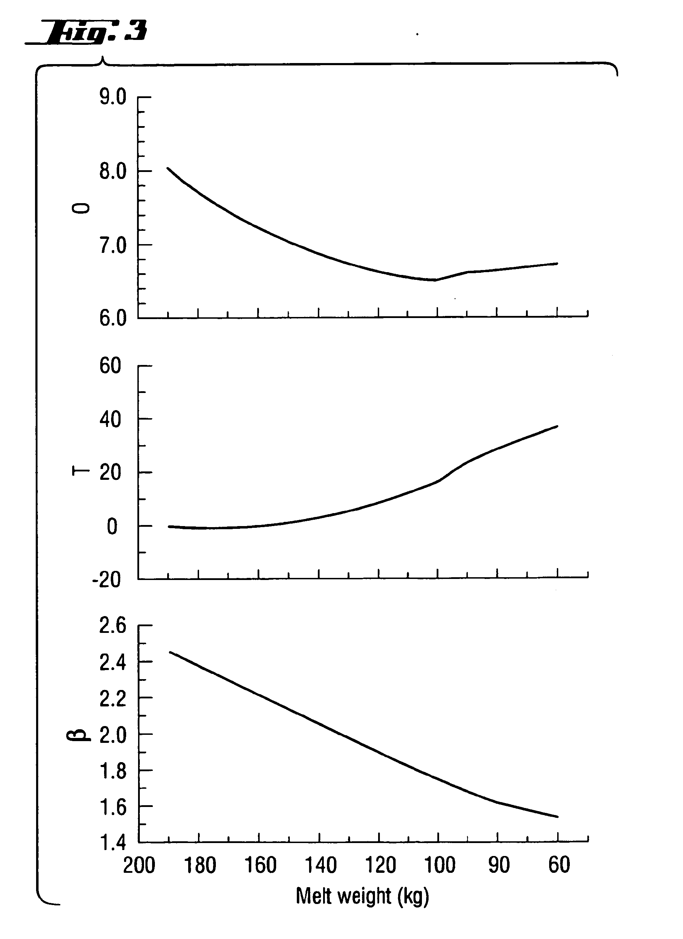

As a comparative example in the present invention, it is explained for an example in crystal growth when no changes are done for control parameters such as crucible rotation rate, crystal growing rate, relation between heater and crucible positions, and power distribution of each heater. Fig. 3 shows the following measurements versus the change of melt weight in the growth: the measurements of ratio $\beta$ of contact area, crucible temperature T, oxygen concentration in a grown crystal in a single crystal growth of 12 inch diameter after 200 kg of polycrystalline silicon are filled and melt in a quartz crucible with a size of 28 inch diameter. The crucible temperature T therein is expressed as a difference from the crucible temperature in the growth of the top of a fixed diameter part.

The oxygen concentration of crystal fixed diameter part decreased gradually from the top of the growth, though it increased somewhat at the end of crystal fixed diameter part in the decreased residual melt in a crucible, it gave a large change width resulting in 20% as large as to the average across a whole crystal length of a fixed diameter part. It is thought that the changes are due to a large decrease of ratio $\beta$ of contact area up to the middle period and due to the influence of increase of crucible temperature in the latter period in pulling-up of crystal. It is understood that it is necessary to control by suitably changing the ratio $\beta$ of contact area and crucible temperature T in order to homogenize the oxygen concentrations in crystal.

Example 1

Example 1 corresponds to claims 1 and 3.

In the growth of 12 inch crystal in the same furnace and furnace member constitution as in Comparative example 1, in order that oxygen concentration in crystal becomes uniformly $8.0 \times 10 \, E^{17}$ (atoms/cm$^3$), crucible temperature was controlled by changing a crucible rotation rate in the growth of crystal. Specifically, the crucible rotation rate was kept low in the initial stage of single crystal pulling-up, toward the latter stage of growth it was increased or decreased according to a flow chart shown in Fig. 2. Each of the functions of F, G and H used in the control equation (1) for oxygen concentration is in the form below:

$$F \ (\Omega) \ = \ \Omega^{0.5}$$
$$G \ (T) \ = T+g \qquad \qquad ... \ Equation(7)$$
$$H \ (\beta) \ = \ \beta^{-1}$$

Constants of A, B and g were determined by a least square method from the operational conditions in Example 1 and the actually obtained oxygen concentrations of crystal.

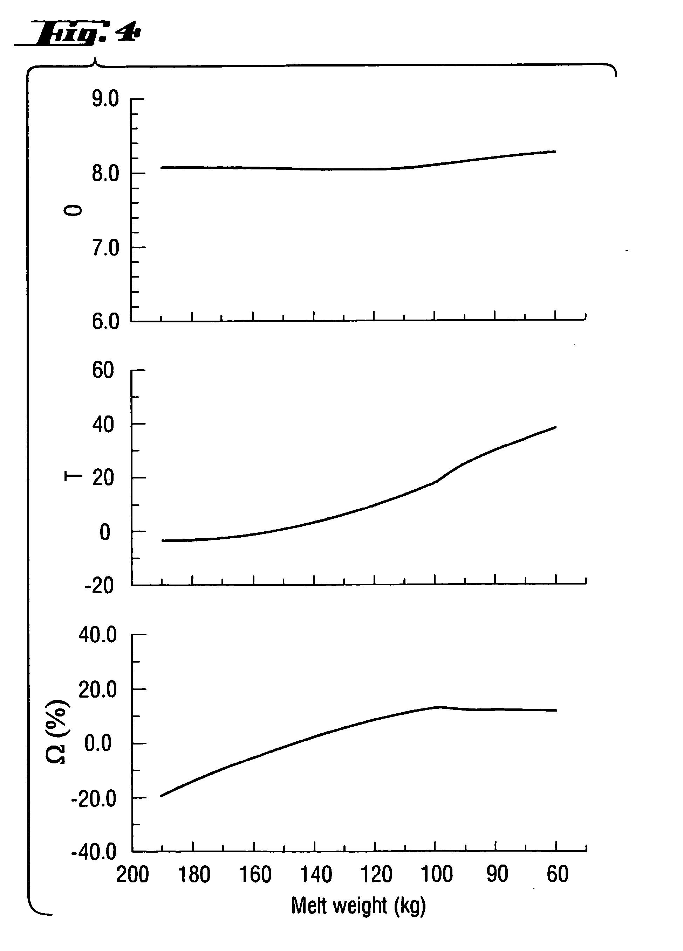

Fig. 4 shows the changes of crucible rotation rate Ω and crucible temperature T. The crucible rotation rate Ω therein represents percentage of the value of rotation rate in Comparative example 1 and the crucible temperature T represents a difference from the crucible temperature in the growth of top of crystal fixed diameter part in Comparative example 1.

The crucible temperature T in Example 1 can raise the crucible rotation rate in Comparative example 1 to compensate the decrease of the ratio β of contact area shown in Fig. 4, as a result, a crystal having a deviation within 4% from a target value of oxygen concentration of 8.0 ×10 E$^{17}$ (atoms/cm$^3$) across a whole length of crystal fixed diameter part was obtained.

Example 2

Example 2 corresponds to claims 2 and 3.

In Example 2, In the growth of 12 inch crystal in the same furnace and hot zone constitution as in Comparative example 1, in order that oxygen concentration in crystal becomes uniformly 8.0 ×10 E$^{17}$ (atoms/cm$^3$), crucible temperature T was controlled by changing a crucible rotation rate Ω in an crystal growth as in Example 1. Specifically, the crucible rotation rate Q was kept low in the initial stage of single crystal pulling-up, toward the latter stage of growth it was increased or decreased according to a flow chart shown in Fig. 2. Each of the functions of F and I used in the estimate equation (5) for oxygen concentration is in the form below:

$$F \ (\Omega) \ = \ \Omega^{0.5}$$

$$I \ (T) \ = \ 1/\beta \times Exp \ (-E/T)$$

Additionally, value E was 24,000 (K) that is a near value known in a reference (T. Carberg, J. Electrochem. Soc., vol. 133, No. 9, p. 1940), constants of A and B were determined by a least square method from the operational conditions in Example 1 and the actually obtained oxygen concentrations of crystal. The error by the least square method became a half of that obtained in Example 1 and the precision of approximation using this equation was better than that in Example 1.

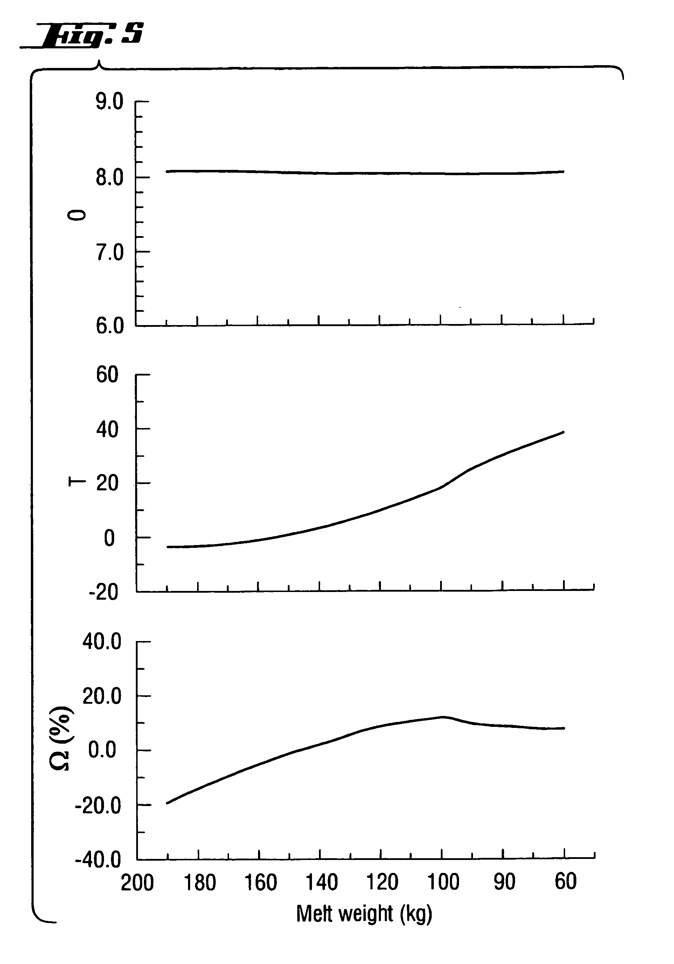

Fig. 5 shows the changes of crucible rotation rate Q and crucible temperature T. The crucible rotation rate Q therein represents percentage of the value of rotation rate in Comparative example 1 and the crucible temperature T represents a difference from the crucible temperature in the growth of top of crystal fixed diameter part in Comparative example 1.

The crucible temperature T in Example 2 was also able to raise the crucible rotation rate Q in Comparative example 1 to compensate the decrease of the ratio β of contact area, as a result, a crystal with a better uniformity than that in Example 1 was obtained, having a deviation within 2% from a target value of oxygen concentration of 8.0 ×10 E$^{17}$ (atoms/cm$^3$) across a whole length of crystal fixed diameter part.

Example 3

Example 3 corresponds to claims 3 and 4.

In Example 3, in an initial stage of crystal growth, the change of crucible rotation rate Ω was performed in the same pattern as in Example 2, from the midstream of growth, the crucible rotation rate Q was fixed at the same rotation rate as in Comparative example 1, and then, the change of crucible temperature T was carried out by adjusting power supplying to the auxiliary heater 6. In addition, Equation (5) was used as an estimate equation with the same functions F and I used as in Example 2 and also with constants A, B and E used as in Example 2.

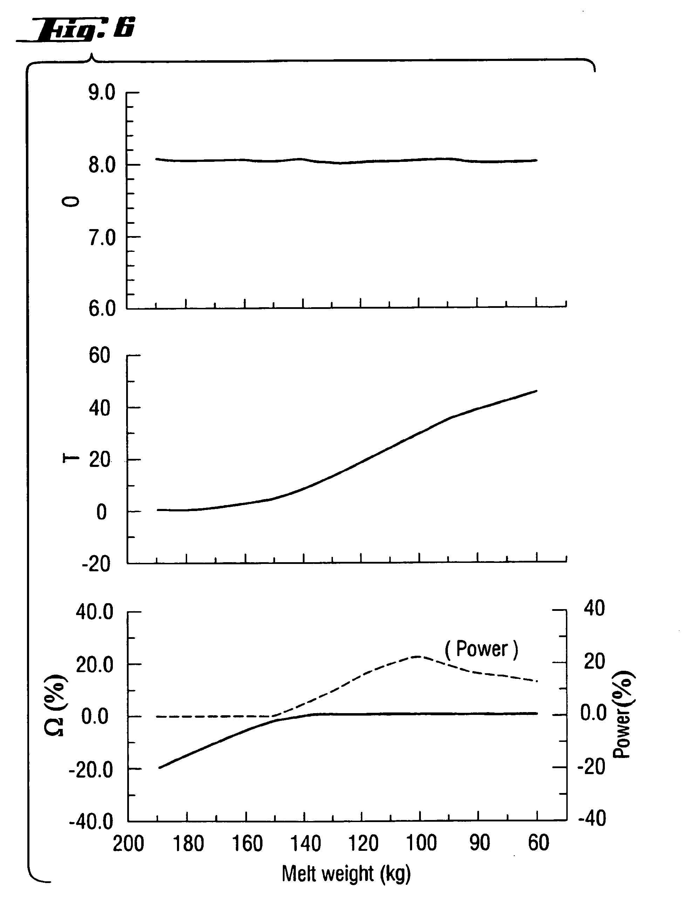

Fig. 6 shows the changes of each of operational parameters (crucible rotation rate Ω and power to the auxiliary heater 18S) and crucible temperature T. The crucible rotation rate Ω and power to the auxiliary heater 18S therein represent percentages of the values of in Comparative example 1 and the crucible temperature T represents a difference from the crucible temperature in the growth of top of crystal fixed diameter part in Comparative example 1.

The crucible temperature T in Example 3 was also able to raise to compensate the decrease of the ratio β of contact area, as a result, a crystal having a deviation within 2% from a target value of oxygen concentration of 8.0 ×10

$E^{17}$ (atoms/cm$^3$) across a whole length of crystal fixed diameter part was obtained.

Example 4

Example 4 corresponds to claim 5.

In Example 4, in an initial stage of crystal growth, the change of crucible rotation rate Ω was performed in the same pattern as in Example 2, from the midstream of growth, the crucible rotation rate Q was fixed at the same rotation rate as in Comparative example 1, and then, the change of crucible temperature T was carried out by changing a relative position between the main heater 5 and melt surface with the crucible shaft hoisting servomotor 7b. In addition, Equation (5) was used as an estimate equation with the same functions F and I used as in Example 2 and also with constants A, B and E used as in Example 2.

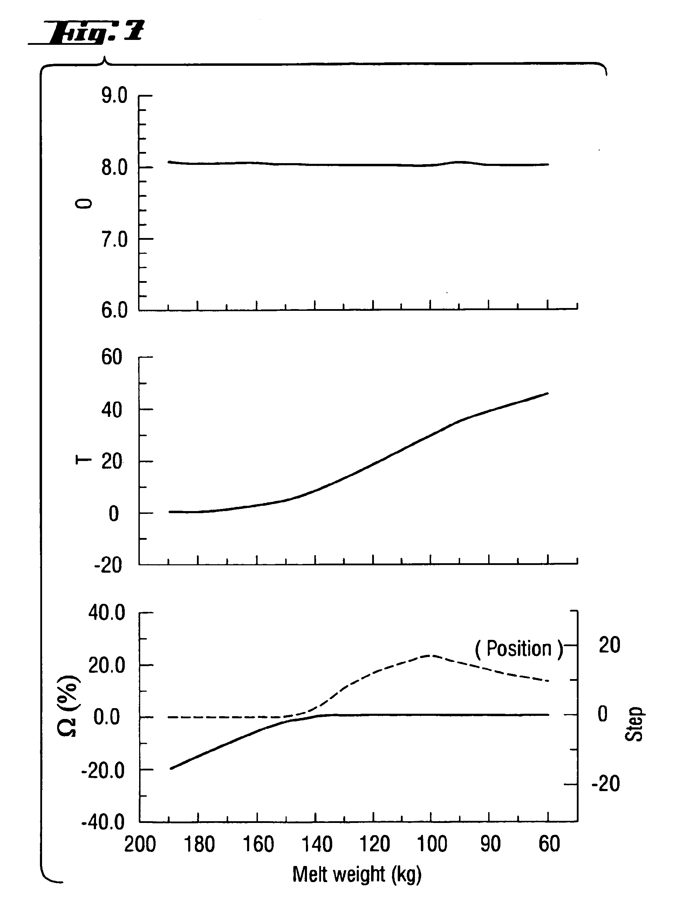

Fig. 7 shows the changes of each of operational parameters (crucible rotation rate Ω and crucible position Step) and crucible temperature T. The crucible rotation rate Ω therein represents percentage of the value of rotation rate in Comparative example 1 and crucible position Step represents the moving step number of crucible hoisting servomotor 7b from Comparative example 1 and the crucible temperature T represents a difference from the crucible temperature in the growth of top of crystal fixed diameter part in Comparative example 1. The crucible temperature T in Example 4 was also able to raise to compensate the decrease of the ratio β of contact area, as a result, a crystal having a deviation within 2% from a target value of oxygen concentration of $8.0 \times 10$ $E^{17}$ (atoms/cm$^3$) across a whole length of crystal fixed diameter part was obtained.

Example 5

Example 5 corresponds to claim 6.

In Example 5, in an initial stage of crystal growth, the change of crucible rotation rate Q was performed in the same pattern as in Example 2, from the midstream of growth, the crucible rotation rate Q was fixed at the same rotation rate as in Comparative example 1, and then, the change of crucible temperature T was carried out by changing crystal growth rate. In addition, Equation (5) was used as an estimate equation with the same functions F and I used as in Example 2 and also with constants A, B and E used as in Example 2.

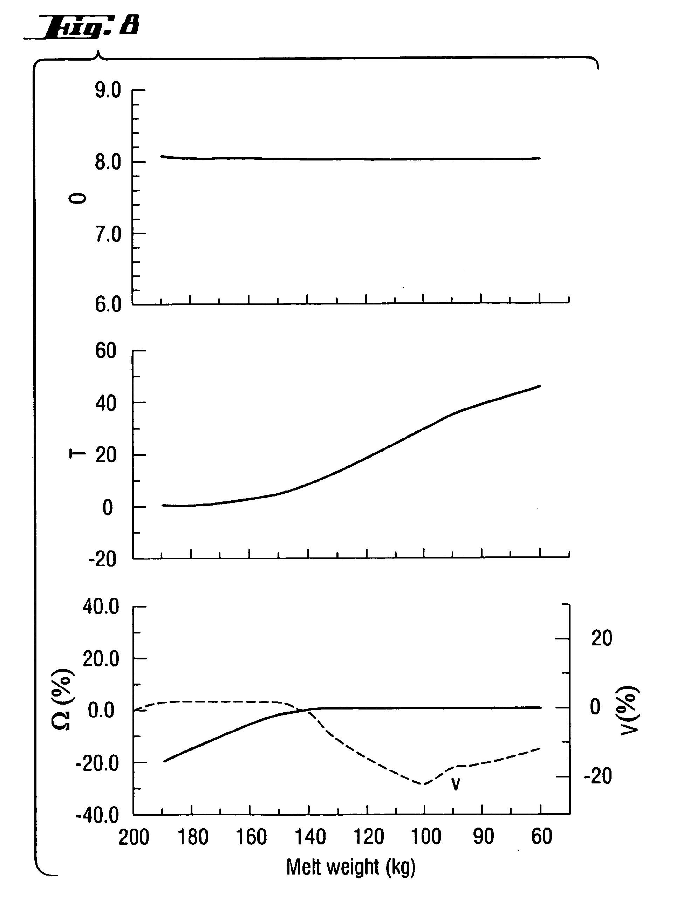

Fig. 8 shows the changes of each of operational parameters (crucible rotation rate Q and crystal growing rate) and crucible temperature T. The crucible rotation rate Ω and crystal growing rate therein represent percentages of those values in Comparative example 1, and the crucible temperature T represents a difference from the crucible temperature on the top of crystal fixed diameter part in Comparative example 1. The crucible temperature T in Example 5 was also able to raise to compensate the decrease of the ratio β of contact area, as a result, a crystal having a deviation within 2% from a target value of oxygen concentration of $8.0 \times 10$ $E^{17}$ (atoms/cm$^3$) across a whole length of crystal fixed diameter part was obtained.

Example 6

In Example 6, instead of the oxygen concentration of $8.0 \times 10$ $E^{17}$ (atoms/cm$^3$) obtained in Example 3, an aim was to obtain a crystal with a higher oxygen concentration of $9.0 \times 10$ $E^{17}$ (atoms/cm$^3$). Namely, the change of crucible rotation rate Q was performed under the same conditions as the crucible rotation rate of Example 3 to promote oxygen to elute from crucible at a higher crucible temperature T than that in Example 2 by changing power to the auxiliary heater 6. In addition, Equation (5) was used as an estimate equation with the same functions F and I used as in Example 2 and also with constants A, B and E used as in Example 2.

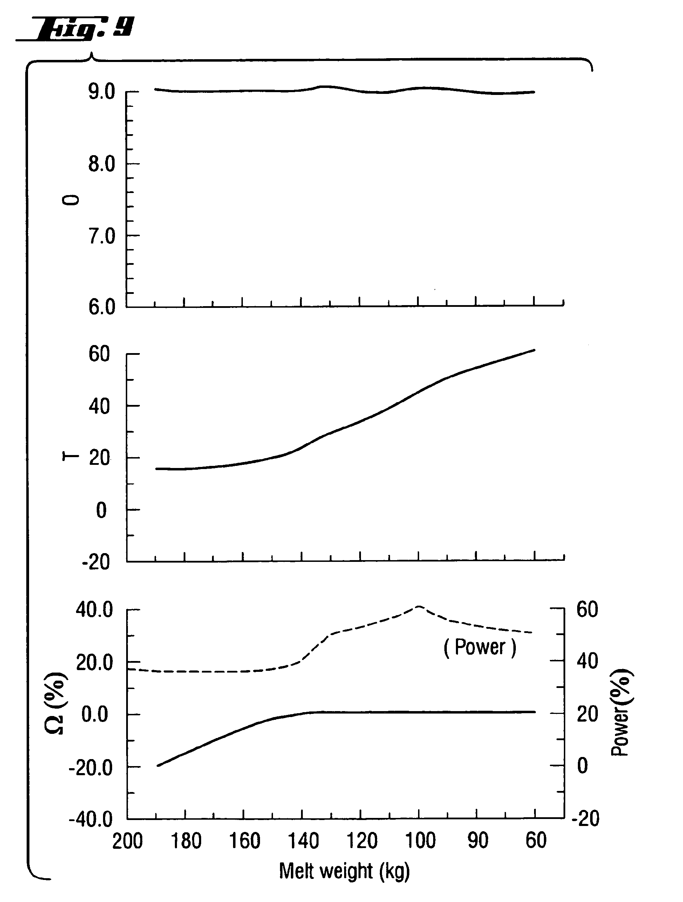

Fig. 9 shows the changes of each of operational parameters (crucible rotation rate Ω and power to the auxiliary heater 6) and crucible temperature T. The crucible rotation rate Q and power to the auxiliary heater 6 therein represent percentages of the values in Comparative example 1, and the crucible temperature T represents a difference from the crucible temperature on the top of crystal fixed diameter part in Comparative example 1. The crucible temperature T in Example 6 was also able to raise to compensate the decrease of the ratio β of contact area, as a result, a crystal having a deviation within 2% from a target value of oxygen concentration of $9.0 \times 10$ $E^{17}$ (atoms/cm$^3$) across a whole length of crystal fixed diameter part was obtained.

Example 7

In Example 7, instead of the oxygen concentration of $8.0 \times 10$ $E^{17}$ (atoms/cm$^3$) obtained in Example 3, an aim was to obtain a crystal with a lower oxygen concentration of $7.0 \times 10$ $E^{17}$ (atoms/cm$^3$). Namely, the change of crucible

rotation rate $\Omega$ was performed under the same conditions as the crucible rotation rate of Example 3 to suppress the oxygen eluted from crucible at a lower crucible temperature T than that in Example 2 by changing power to the auxiliary heater 6a. In addition, Equation (5) was used as an estimate equation with the same functions F and I used as in Example 2 and also with constants A, B and E used as in Example 2.

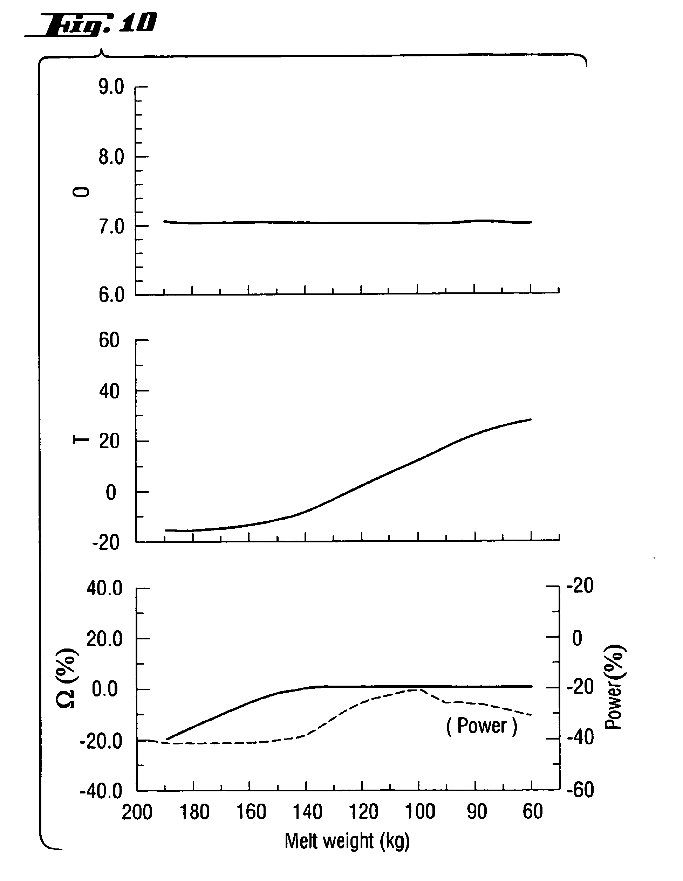

Fig. 10 shows the changes of each of operational parameters (crucible rotation rate $\Omega$ and power to the auxiliary heater 6) and crucible temperature T. The crucible rotation rate $\Omega$ and power to the auxiliary heater 18S therein represent percentages of the values in Comparative example 1, and the crucible temperature T represents a difference from the crucible temperature on the top of crystal fixed diameter part in Comparative example 1. The crucible temperature T in Example 7 was also able to raise to compensate the decrease of the ratio $\beta$ of contact area, as a result, a crystal having a deviation within 2% from a target value of oxygen concentration of $7.0 \times 10 \, E^{17}$ (atoms/cm$^3$) across a whole length of crystal with a fixed diameter was obtained.

As described above, in the production process of the present invention, based on focusing the attention that a distribution of oxygen concentration in the axial direction of silicon single crystal depends on crucible rotation rate, crucible temperature, contact areas of molten silicon with quartz crucible 4 and atmosphere gas, as a parameter controlling the crucible temperature T, any one of crucible rotation rate, heating temperature of heater and crystal pulling-up speed, or a combination thereof was used. According to the production process, the distribution of oxygen concentration in the axial direction of silicon single crystal can be homogenized and the production yield of silicon single crystal can be improved. Additionally, using none of crystal length, solidification rate of melt or melt amount in pulling-up in the conventional methods, but using ratio $\beta$ of contact area as a control indicator, therefore, the process has an advantage not to be affected by the changes of crystal diameter and initial amount of melt feedstock.

Brief description of the drawings

Fig.1 is a schematic view depicting an embodiment of production apparatus used in production of silicon single crystal according to the production process of the present invention.

Fig. 2 is a flow diagram showing a control procedure of various operational parameters in pulling-up of silicon single crystal.

Fig. 3 is a figure showing a relation between operational parameters (T and $\beta$) and oxygen concentration (O) in Comparative example.

Fig. 4 is a figure showing a relation between operational parameters (T and $\Omega$) and oxygen concentration (O) in Example 1.

Fib. 5 is a figure showing a relation between operational parameters (T and $\Omega$) and oxygen concentration (O) in Example 2.

Fig. 6 is a figure showing a relation between operational parameters (T, $\Omega$ and Power) and oxygen concentration (O) in Example 3.

Fig. 7 is a figure showing a relation between operational parameters (T, $\Omega$ and Position) and oxygen concentration (O) in Example 4.

Fig. 8 is a figure showing a relation between operational parameters (T, $\Omega$ and V) and oxygen concentration (O) in Example 5.

Fig. 9 is a figure showing a relation between operational parameters (T, $\Omega$ and Power) and oxygen concentration (O) in Example 6.

Fig.10 is a figure showing a relation between operational parameters (T, $\Omega$ and Power) and oxygen concentration (O) in Example 7.

Description of number and symbol

1 Production apparatus
2 Pulling furnace
3 Crucible shaft
4 Quartz crucible
5 Main heater
5a Source of main heater
6 Auxiliary heater
6a Source of auxiliary heater

7 Crucible support shaft drive mechanism
7a Crucible rotating servomotor
7b Crucible hoisting servomotor
8 Seed crystal
9 Seed chuck
10 Pulling wire
11 Wire winding mechanism
11a Wire winding servomotor
11b Load cell
12 Controller
13 Silicon single crystal
14 Molten silicon
15 Thermocouple
16 Radiation thermometer

**Claims**

1. A production process for silicon single crystal by Czochralski method using quartz crucible, comprising:

estimation of oxygen concentration in a silicon single crystal in the growth on the basis of a relation of three parameters among a crucible rotation rate ($\Omega$), a crucible temperature (T),
and a ratio ($\beta$) of a contact area of molten silicon with an inner wall of crucible and a contact area of molten silicon with an atmosphere gas; controlling at least one of the crucible rotation rate ($\Omega$) and the crucible temperature (T) and
controlling the oxygen concentration in the silicon single crystal by associating the temperature (T) with the ratio ($\beta$) by $1/\beta \times Exp$ (-E/T)
as a function using a dissolution energy (E) of quartz into molten silicon to conform the oxygen concentration estimated to a target concentration.

2. The production process for silicon single crystal of claim 1 wherein the rotation rate ($\Omega$) is controlled in response to changes of the ratio ($\beta$) and the temperature (T).

3. The production process for silicon single crystal of claim 1 wherein power supplying to a heater heating the crucible is controlled in response to changes of the rotation rate ($\Omega$) and the ratio ($\beta$).

4. The production process for silicon single crystal of claim 1 wherein a relative position between the crucible and the heater heating the crucible is controlled in response to changes of the rotation rate ($\Omega$) and the ratio ($\beta$).

5. The production process for silicon single crystal of claim 1 wherein a growth rate of silicon single crystal is controlled in response to changes of the rotation rate ($\Omega$) and the ratio ($\beta$).

**Patentansprüche**

1. Produktionsprozess für Siliziumeinkristall durch ein Czochralski-Verfahren unter Verwendung eines Quarztiegels, umfassend:

Schätzung einer Sauerstoffkonzentration in einem Siliziumeinkristall bei dem Aufwachsen auf der Basis einer Relation von drei Parametern unter einer Tiegelrotationsrate ($\Omega$), einer Tiegeltemperatur (T) und einem Verhältnis ($\beta$) eines Kontaktbereichs von geschmolzenem Silizium mit einer Innenwand des Tiegels und einem Kontaktbereich von geschmolzenem Silizium mit einer Gasatmosphäre; Steuern mindestens einer der Tiegelrotationsrate ($\Omega$) und der Tiegeltemperatur (T) und
Steuern der Sauerstoffkonzentration in dem Siliziumeinkristall durch Assoziieren der Temperatur (T) mit dem Verhältnis ($\beta$) durch $1/\beta xExp$ (-E/T)
als Funktion unter Verwendung einer Lösungsenergie (E) von Quarz in geschmolzenes Silizium, um die geschätzte Sauerstoffkonzentration einer Zielkonzentration anzupassen.

**2.** Produktionsprozess für Siliziumeinkristall nach Anspruch 1, wobei die Rotationsrate (Ω) als Reaktion auf Änderungen bei dem Verhältnis (β) und der Temperatur (T) gesteuert wird.

**3.** Produktionsprozess für Siliziumeinkristall nach Anspruch 1, wobei einer den Tiegel heizenden Heizvorrichtung zugeführte Leistung als Reaktion auf Änderungen bei der Rotationsrate (Ω) und dem Verhältnis (β) gesteuert wird.

**4.** Produktionsprozess für Siliziumeinkristall nach Anspruch 1, wobei eine relative Position zwischen dem Tiegel und der den Tiegel heizenden Heizvorrichtung als Reaktion auf Änderungen bei der Rotationsrate (Ω) und dem Verhältnis (β) gesteuert wird.

**5.** Produktionsprozess für Siliziumeinkristall nach Anspruch 1, wobei eine Wachstumsrate von Siliziumeinkristall als Reaktion auf Änderungen bei der Rotationsrate (Ω) und dem Verhältnis (β) gesteuert wird.

**Revendications**

**1.** Procédé de production d'un monocristal de silicium par la méthode Czochralski utilisant un creuset en quartz, comprenant :

l'estimation de la concentration d'oxygène dans un monocristal de silicium en croissance en fonction d'une relation à trois paramètres entre la vitesse de rotation du creuset (Ω) , la température du creuset (T) et le rapport (β) entre la surface de contact du silicium fondu avec la paroi interne du creuset et la surface de contact du silicium fondu avec une atmosphère gazeuse ;
le contrôle de la vitesse de rotation du creuset (Ω) et/ou de la température de creuset (T) ; et
le contrôle de la concentration d'oxygène dans le monocristal de silicium par association de la température (T) avec le rapport (β) par $1/\beta \times Exp(-E/T)$ comme une fonction utilisant l'énergie de dissolution (E) du quartz dans le silicium fondu pour faire correspondre la concentration d'oxygène estimée avec une concentration cible.

**2.** Procédé de production d'un monocristal de silicium selon la revendication 1 dans lequel la vitesse de rotation (Ω) est contrôlée en réponse à des changements du rapport (β) et de la température (T).

**3.** Procédé de production d'un monocristal de silicium selon la revendication 1 dans lequel l'alimentation d'un dispositif de chauffage chauffant le creuset est contrôlée en réponse à des changements de la vitesse de rotation (Ω) et du rapport (β).

**4.** Procédé de production d'un monocristal de silicium selon la revendication 1 dans lequel la position relative entre le creuset et le dispositif de chauffage chauffant le creuset est contrôlée en réponse à des changements de la vitesse de rotation (Ω) et du rapport (β).

**5.** Procédé de production d'un monocristal de silicium selon la revendication 1 dans lequel la vitesse de croissance du monocristal de silicium est contrôlée en réponse à des changements de la vitesse de rotation (Ω) et du rapport (β).

**Fig. 1**

**Fig. 2**

```
┌─────────────────┐ S11        ┌─────────────────┐ S21        ┌─────────────────┐ S31
│   Load cell     │            │ Crucible rotating│           │ Thermometer of  │
└─────────────────┘            │   servomotor    │            │ crucible bottom │
        │                      └─────────────────┘            └─────────────────┘
        ▼                              │                              │
┌─────────────────┐ S12               ▼                              ▼
│ Read in crystal │            ┌─────────────────┐ S22        ┌──────────────────┐ S32
│     weight      │            │ Read in crucible│            │Read in temperature│
└─────────────────┘            │  rotation rate  │            │ of crucible bottom│
        │                      └─────────────────┘            └──────────────────┘
        ▼
┌─────────────────┐ S13
│ Calculation of  │
│ evaporating area│
└─────────────────┘
        │
        ▼
┌─────────────────┐ S14
│ Calculation of  │
│  contact area   │
└─────────────────┘
        │
        ▼
┌─────────────────┐ S15
│ Calculation of β│
└─────────────────┘
```

```
              ┌──────────────────────┐ S41
              │ Calculation of estimated│
              │  oxygen concentration │
              └──────────────────────┘
                       │
                       ▼
              ┌──────────────────────┐ S42
              │ Comparison with planned│
              │  oxygen concentration │
              └──────────────────────┘
                       │
                       ▼
              ┌──────────────────────┐ S43
              │   Logic for selection │
              │  of control procedure │
              └──────────────────────┘
```

```
┌─────────────────┐ S51  ┌─────────────────┐ S61  ┌──────────────────┐ S71  ┌─────────────────┐ S81
│  Adjustment of  │      │  Adjustment of  │      │Adjustment of crucible│   │  Adjustment of  │
│crucible rotation rate│ │ pulling-up speed │     │ and heater positions │   │  heater power   │
└─────────────────┘      └─────────────────┘      └──────────────────┘      └─────────────────┘
        │                        │                         │                         │
        ▼                        ▼                         ▼                         ▼
┌─────────────────┐ S52  ┌─────────────────┐ S62  ┌──────────────────┐ S72  ┌─────────────────┐ S82
│    Crucible     │      │      Wire       │      │    Crucible      │      │ Source of heater│
│rotating servomotor│    │winding servomotor│     │hoisting servomotor│      │                 │
└─────────────────┘      └─────────────────┘      └──────────────────┘      └─────────────────┘
```

*Fig. 3*

Fig. 4

# _Fig. 5_

Fig. 6

Fig. 1

Fig. 8

Fig. 9

## Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H05262593 A
- JP H06172081 A
- WO H09157085 A
- JP H10167881 A

- JP H06316481 A
- JP 56125296 A
- JP H06298593 A
- JP H06219887 A

**Non-patent literature cited in the description**

- Oxygen concentration in Czochralski silicon crystals depending on silicon monoxide evaporation from boron doped silicon melts. **Maeda et al.** Journal Of Crystal Growth. Elsevier, 15 August 1998, vol. 192, 117-124

- **HOSHIKAWA ; HIRATA.** *Japanese Association for Crystal Growth Corporation,* 1988, vol. 15.2, 215
- **T. CARBERG.** *J. Electrochem. Soc.,* vol. 133 (9), 1940